# EUROPEAN PATENT APPLICATION

(11) **EP 4 765 535 A1**
(43) Date of publication of application: **24.06.2026**
(21) Application number: 24222317.0
(22) Date of filing: 20.12.2024
(51) Int. Cl.: H02H 7/26, H02H 3/08, H02H 3/02

(54) **PROTECTION ENHANCEMENT DEVICE, PROTECTION SYSTEM, AND PROTECTION METHOD FOR A POWER NETWORK**

(71) Applicant: Hitachi Energy Ltd, 8050 Zürich (CH)
(72) Inventor: Timbus, Adrian, 5507 Mellingen (CH); Round, Simon Douglas, 8032 Zurich (CH); Salge, Gerhard, 8123 Ebmatingen (CH)
(74) Representative: AWA Sweden AB

(57) **Abstract**

There is disclosed herein a protection enhancement device (110) for a power network (200), comprising a control module (112) configured to, in response to a detection of a fault current at a detection location in the power grid, control a power device (120) to inject an additional current to supplement the fault current in the power network to thereby cause a protection response on the power network, and/or control a protection device (120) to initiate a protection response on the power network (200). In the latter case, the detected fault current has a different value to a protection response configuration setting for the protection device at which a protection response of the protection device (120) is caused. Also disclosed herein are associated protection methods performable by devices, and a protection system comprising such devices.

## Description

### Technical Field

The present disclosure relates to components of power transmission networks, also referred to as 'power networks'. More specifically, the present disclosure relates to a protection enhancement device for a power network and an associated protection method performable by such a device. The present disclosure also relates to a protection system comprising such a device.

### Background

The electrical power network has been traditionally a so-called "strong grid" as there are many rotating generators (synchronous machines) connected to supply the loads. When a fault appears, such as a short circuit between a phase and ground, there is an instantaneous change in the system voltage (magnitude/phase angle) that appears at the output of the generator. This results in the generator supplying a large current into the electrical network and to the fault. This current is referred to as a fault current or a 'short-circuit' current.

As this fault current typically exceeds a certain threshold, conventional intelligent electronic (protection) devices (IEDs) detect this excessive current and signal a circuit breaker to open to thereby break the fault current. Once open, the point of the fault is isolated from the rest of the power network and the power system is protected.

As the power network (or 'power grid' or simply 'grid' for short) is transitioning to include more and more renewable energy sources into the generation mix, the grid is become weaker as the connected power electronic (PE) converters' ability to supply fault currents is reduced. Therefore, when there is a dominance of PE converters in the grid, today's protection devices may not detect a sufficient fault current level to trip the protection equipment, e.g., circuit breakers. Therefore, the fault may remain and continue to cause excessive currents to flow, with an increasing likelihood of equipment damage if the fault is not removed from the power system.

There is therefore a need for a protection system that can provide an additional fault current in a controllable way to allow the existing and future protection devices (such as circuit breakers) to reliably clear any grid faults, even as the grid becomes weaker, with less or even no rotating mass generators in the grid.

### Summary

Aspects of the present disclosure address, among other things, a problem of having insufficient short circuit current/fault current capability in the power grid. Viewed from one perspective, this problem is addressed by providing real power/energy into the grid to feed faults and thereby enabling protection devices on the power grid to operate.

Specifically, according to an aspect of the present disclosure, there is provided a protection enhancement device for a power network, comprising a control module. The control module is configured to, in response to a detection of a fault current at a detection location in the power grid, control a power device to inject an additional current to supplement the fault current in the power network to thereby cause a protection response on the power network.

The protection enhancement device may be a processing device and the control module may be a hardware or software module of said processing device. The protection enhancement device (or `PED' for short) may be implemented as a standalone installation on the power network, e.g., alongside or in place of an IED installation on a power line, platform, and/or the PED may be implemented as an add-on for a converter station or substation.

**The** PED is preferably configured to communicate, via a wired or wireless connection, with the power device, to provide a control signal thereto. The PED may be installed alongside the power device or remote from the power device.

**According** to a further aspect of the present disclosure, there is provided a protection method for a power network comprising, in response to an indication of a fault current at a location on the power network, controlling a power device to provide an additional fault current to the power grid to thereby cause a protection response on the power network. This method may be performed by the PED as described above, specifically by the control module thereof. That is, the method may be a computer-implemented or automated method, and may thus be provided as a computer program and/or stored on computer-readable media or the like.

Put another way, aspects of the present disclosure provide a protection enhancement device that, in response to a detected fault, causes an additional current/energy to be injected into the grid during the fault. The device can thus be added to electrical grids with a low short circuit capacity (SCC) to provide reliable protection during fault conditions to effectively emulate a grid with a high SCC.

Additionally, the device can be added to grids to further increase the SCC so that more inverter-based resources can be added to the network. In either case, the additional fault current injected allows for existing protection devices to identify the fault condition and to command the circuit breaker to open and clear the fault (or some other fault response).

The control module may be configured to control the injection of the additional fault current to increase the total current on the power network to above a protection response configuration setting where a protection response is caused on the power network. The control may be performed via real-time control of the power device, or via a control signal that triggers a predetermined response from the power device. In either case, the power device is caused, as a result, to inject an additional fault current to the power network which brings the total current value (e.g., a magnitude or rate of change of current) to a level that triggers a response, e.g., from the IEDs/circuit breakers on the power network. It will be appreciated that the total current value may only exceed the protection response configuration setting in the substantial proximity of the protection devices intended to be caused to respond.

The protection response configuration setting may be set on a device-by-device basis and may be a static or dynamic setting, depending on the nature of the protection devices present on the power network. The protection response configuration setting may, for example, be set externally from the protection devices themselves, e.g., from some main protection controller. Alternatively, the protection response configuration setting may be inherent to the protection device itself (e.g., if the protection device is a passive, non-intelligent device).

It will be appreciated that the protection enhancement device may not be provided or kept updated with the particular value of the protection response configuration setting for a protection device intended to the triggered, but an estimation or assumption of this value may be adopted, with the additional fault current being configured to exceed this estimated or assumed value.

In some examples, the PED may control the power device to inject an additional fault current that increases with time, e.g., in steps or continuously, until it is determined or assumed that a protection response has been caused on the power network. In this way, an actual knowledge of the protection response configuration setting may not be required, and a minimal-required additional fault current to trigger a protection response can be provided, thus improving efficiency, preventing unnecessary energy expenditure.

In a preferred example, the value (magnitude, rate of change, and/or profile) of the additional current is designed in view of protection device (e.g., IED) settings, to cause a protection response in the power network, such settings being known in advance or communicated to the protection enhancement device.

In any event, the control module may be configured to stop injecting the additional fault current into the power network in response to a determination that the protection response has been caused and/or a determination that a predetermined amount of energy has been injected into the power network, depending on the desired complexity of the device. For example, a central controller may detect that the fault has been successfully isolated, and instruct the additional current injection to stop. As another example, the control module may determine itself or via a coupled (protection) device that a protection response has been successfully triggered.

The fault may be detected by a detection module configured to detect the fault current at the detection location. The detection module may comprise sensing and/or monitoring means configured to monitor the current (or some other property) for abnormalities at the detection location. The detection module may thus be hardware and/or software, and preferably physically integrated within the same device as the control module so as to reduce a latency of communication therebetween. The detection module may communicate, via wired or wireless means, with the control module so as to provide an indication of a fault current to the control module.

In an example, the detection module may be at a detection location different from a point of injection of the additional fault current, such as different branches in a power network. Such an arrangement may be particularly advantageous in a scenario where the protection enhancement device (having a detection module integrated therein) is itself part of a converter system.

Detecting a fault current comprises determining that a current value at the detection location exceeds a threshold current value, where a current value may be a current magnitude and/or a rate of change of current. Such abnormal behavior in the current on a power network is typically associated with a fault. It will be appreciated that, instead of (or in addition to) using current as an indicator of a fault (current), the voltage and/or frequency may be monitored for abnormalities or deviations. It will also be appreciated that the detection module may monitor for particular profiles or features (e.g., fast-transient signals or the like), rather than comparing to a threshold.

**The** threshold current value is preferably substantially higher than a nominal current value at the detection location, and lower than the protection response configuration setting. In this way, the PED may only respond if a 'normal' protection response would not otherwise be triggered based on the current behavior on the power network in response to the fault.

**The** detection of a fault current may also comprise receiving an indication that a fault current has been detected on the power network. The control module may also be further configured to, in response to the detection of a fault current at a detection location in the power network, transmit (e.g., to a central controller or a broadcast to many systems) an indication that a fault current has been detected on the power network. In this way, a control module may not require a direct coupling with a detection module or other device that detects the fault current - the presence of the fault current may be communicated from a central controller or the like as part of a coordinated response across the power network.

In an example implementation, the power network may be provided with a plurality of power enhancement devices, each instructing one or more of (the same or different) power devices to inject an additional current into the power network. In this way, each power device may not be expected to provide an additional current that triggers a protection response, but a plurality of additional currents may together contribute to an overall additional current that causes a protection response of the power network.

Each power enhancement device may be provided with a respective detection module or at least some may share one or more detection modules between them. In general, an interconnected protection network may be formed, which may be overseen by a centralized control system for the power network. From such an overview, a fault detected in one part of the power network may cause a plurality of protection enhancement devices to control one or more power devices to inject an additional current into the power network. In this way, the SCC of the power network may be greatly enhanced, even with a high penetration of renewable power generation and non-rotating static power devices/converters.

According to a further aspect of the present disclosure, there is provided a protection system comprising a protection enhancement device substantially as described above, and further comprising the power device configured to provide the additional fault current from an energy storage into the power network in response to a control from the control module. The protection system may be formed as an integrated unit, or as a distributed system. The protection system may further comprise the energy storage, either integrated into a same unit or separately from the protection enhancement device and/or the power device.

**The** power device is preferably a static device, i.e., a device that does not employ a rotating mass. As a specific preferred example of a static device, the power device is a power electronic (PE) converter.

In an example implementation, the static device comprises a dedicated, oversized, cell of a power electronic converter that is otherwise deployed as a grid-coupled converter for providing power to the power network. The dedicated cell may be coupled to a similarly dedicated power source (e.g., a capacitor). In such an example, the protection enhancement device may be formed as part of the converter station systems, such that a substantially integrating system is provided.

In another example implementation, the protection enhancement device, power device, and energy storage are integrated into the same unit, which can be installed on a power line, e.g., on a platform or pylon. In this way, the integrated unit can be installed at a targeted location on the power network that would particularly benefit from an increased SCC.

The energy storage may comprise one or more of electrical energy storage (e.g., a capacitor), chemical energy storage (e.g., a battery or fuel cell), thermal energy storage, gravitational potential energy storage, and elastic potential energy storage. Faster responding energy storages (e.g., a capacitor or battery) may be paired with slower responding, but simpler energy storages, such as simple mechanical systems exploiting gravitational potential energy.

**The** energy storage may be configured to be replenished from the power network. For example, a capacitor or battery may be recharged from the grid, or water may be pumped against gravity using power from the power network. In this way, the protection enhancement device may be readily and automatically reset, increasing the availability of a protection response on the power network.

The protection system may also comprise an energy storage monitoring module, provided as hardware and/or software, in the PED or elsewhere. The energy storage monitoring module may be configured to maintain the energy storage at a threshold/minimum energy level, where the minimum energy level may correspond to an amount of energy desired for injection into the power network under control of the PED.

It will be appreciated that aspects of the present disclosure are not limited to AC grids but are also applicable to DC grids. Moreover, aspects of the present disclosure may be deployed as a stand-alone system, such as a separate PE converter, or the functionality may alternatively be added to an existing PE converter or the like.

According to yet further aspects of the present disclosure, it is considered that, instead of causing a power device to inject an additional fault current, the protection enhancement device is configured to, e.g., via the control module, directly cause a protection response when a fault current is detected. That is, while protection devices such as IEDs may monitor grid conditions such as current to determine when a protection response should be initiated, these protection devices may also be configured to initiate a protection response on demand. For such cases, the control module may, in response to obtaining an indication of a fault on the power grid, send an instruction to a protection device to cause a protection response.

Put another way, there is provided a protection enhancement device for a power network, comprising a control module configured to, in response to a detection of a fault current at a detection location in the power grid, control a protection device to initiate a protection response on the power network. Said detected fault current has a different (e.g., lower) value to a protection response configuration setting for the protection device at which a protection response of the protection device is (normally) caused.

Viewed from another perspective, a protection method is provided, where, in response to an indication of a fault current at a location on the power network, a protection device is controlled to initiate a protection response on the power network. The detected fault current has a different value to a protection response configuration setting for the protection device at which a protection response of the protection device is caused.

According to such an approach, protection devices may be triggered without a current level on the power network exceeding a protection response configuration setting for the protection devices. Nonetheless, as with previously described aspects of the present disclosure, a desired protection response can be obtained even on a power network with a low SCC.

It will be appreciated that such functionality may be combined with any previously described functionality, e.g., as a redundancy. This may further increase the reliability of causing the protection response. In some examples, the PED may cause one or more power devices to inject an additional fault current at one location in the power network (e.g., in one branch), and may further send a signal to one or more protection devices other location(s) in the power network (e.g., in another branch) to 'directly' cause a protection response.

An advantage of such an approach may be to provide flexibility and to have a protection enhancement device in a converter or in a location different from that of the protection device(s), or to operate multiple protection devices via a single protection enhancement device.

Generally, it is seen that aspects of the present disclosure provide improved protection responses for a power network, via direct or indirect causation of a protection response even when there is a low SCC on the power network such that a conventional protection response cannot be triggered.

### Brief Description of the Drawings

One or more embodiments of the present disclosure will be described, by way of example only, and with reference to the following drawings (or 'figures'), in which:
Figure 1 schematically shows an example protection system for a power network;
Figure 2 shows example operations of a grid circuit breaker during a short-circuit fault for a grid with high short-circuit current 2(a), with low short-circuit current without protection system 2(b) and with low short-circuit current with a protections system 2(c); and
Figure 3 shows an example power network having protection systems installed thereon.

### Detailed Description

The present disclosure is described in the following by way of a number of illustrative examples. It will be appreciated that these examples are provided for illustration and explanation only and are not intended to be limiting on the scope of the present disclosure. Instead, the scope of the present disclosure is defined by the appended claims.

Furthermore, although embodiments be presented individually for the sake of focused discussion of particular features, it will be recognized that the present disclosure also encompasses combinations of the embodiments described herein.

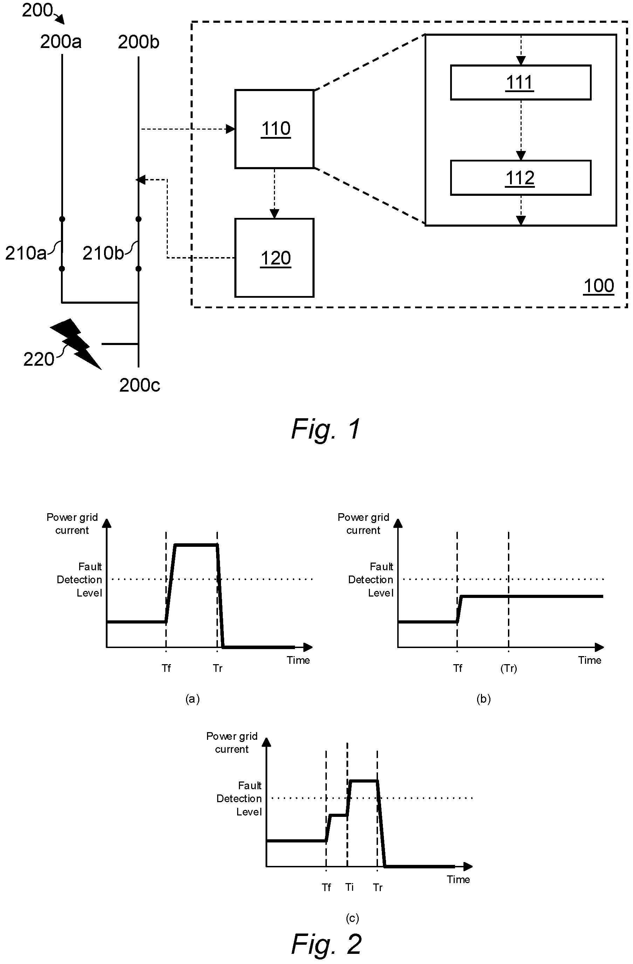

Figure 1 schematically shows a power network 200 (or 'grid 200'), comprising lines 200a, 200b, and 200c, for example (sub)transmission lines, distribution lines, underground power lines or overhead power lines. It can be seen that, in this example, lines 200a and 200b are separate branches (e.g., from separate power sources or to different loads) which come together to be mutually coupled to the line/branch 200c.

In traditional, so-called "strong" power grids, many rotating generators are connected to supply the loads. Upon a fault 220 on the line 200c, such as a short-circuit fault, a short-circuit current is provided into the network by these generators, which may temporarily greatly exceed their regular output current as a consequence of the high amount of energy than can be stored in the magnetic coils of such rotating generators. This current typically exceeds a certain protection threshold and triggers protections devices to open a switch such as switches 210a and/or 210b, thereby isolating the fault 220 from the rest of the network 200.

However, when renewable energy sources are included in the power grid, the grid's capability to detect a fault decreases because the connected power electronic (PE) converters are not capable of providing the same level of fault/short circuit current into the network meaning that the fault current may not be readily detected by the protection devices coupled on the grid 200, and thus a protection response may not be triggered, risking damage to the grid 200 and components thereon.

To address this problem, according to the illustrated example, a protection enhancement device 110 is provided to control a power device 120 to inject a fault current into the network 200. According to this example, the protection enhancement device 110 (or 'PED 110') and the power device 120 together form a protection system 100 for the power network 200.

In this example, the protection enhancement device comprises a detection module 111 and a control module 112 integrated into the same device, although in other examples, these modules 111 and 112 may be deployed separately as software and/or hardware.

**The** detection module 111 monitors the grid 200 (in this example, the detection module monitors the line 200b) and detects the fault 200c in the system, and provides an indication to the control module 112.

Upon detection of the fault, the control module 112 controls the power device 120 to inject an additional fault current into the system 200. The added fault current increases the total current value, i.e., between the injection location and the fault 220. The higher total fault current (i.e., the fault current provided by the converters plus the additional fault current from the power device 120) can then be detected by the protection device, e.g., the switch 210b (shown closed), or a device associated therewith, which in turn reliably clear the fault from the grid. In this example, the detection module 111 has a more sensitive threshold than that which would normally trigger the opening of the switch 210b.

Put another way, the control module 112 is configured to control the injection of the additional fault current to increase the total current on the power network 200 to above a protection response configuration setting where a protection response is caused on the power network 200. The protection response configuration setting may be a value (e.g., magnitude or rate of change of current or voltage or the like) and may be a static or dynamic setting for the protection device 210b at which it triggers a protection response (i.e., in this example, the switch 210b opens).

This control is explained further in connection with figure 2, with subplots (a), (b), and (c), each showing the evolution of power grid current over time in different scenarios.

Figure 2(a) shows the operation of the grid circuit breaker during a short-circuit fault for a grid with high short-circuit current (SCC), and Figure 2(b) for a grid with low short-circuit current. In example case (a), where the grid has a high SCC, when the short-circuit occurs at time Tf, the current increases to a level above the fault detection level, which can be considered as a form of protection response configuration setting. Therefore, a protection device comprising a circuit breaker or the like is caused to initiate a protection response (e.g., opening the circuit breaker) and the fault current stops flowing as the fault is isolated from the power grid.

In example case (b), where the grid has a low SCC, it is seen that the fault results in a current that is below the fault detection level and thus the circuit breaker stays closed and the fault current continues to flow, risking damage.

Figure 2(c) shows the operation of the grid circuit breaker when the protection system 100 from figure 1 is coupled to a grid with low SCC. In this case, the same events happen as in case (b), where the fault results in a short-circuit current below the fault detection level. However, in example case (c), the lower fault current is detected, e.g., by a detection module configured to monitor for fault currents higher than nominal grid current but lower than the fault detection level, and the control module is provided with an indication of a fault. In response to the indication of the fault, the control module causes a power device to inject an additional current into the grid which, as shown in figure 2(c), results in the total grid current, at least in the vicinity of the fault and/or one or more protection devices, rising above the fault detection level. A protection device can then, as with example case (a) respond to the fault, for example by opening a circuit breaker to open to stop the fault current from flowing.

It is appreciated that the detection module 111 and/or the control module 112 can be incorporated into existing intelligent electronic devices (IEDs). IEDs may monitor not only current, but also rate of change of current. Their output can be used by the detection module 111 to detect a fault on the grid. The detection module 111 and/or the control module 112 can be further configured to provide additional functionality, such as communication with other protection devices, modification of protection settings of IEDs and ensuring that there is enough capacity in the grid for safe operation. Alternatively, such additional functionality may be added to the PED 110 through the introduction of further software or hardware modules.

Once the PED 110 been instructed or has detected that the fault has been cleared, or once the PED 110 has calculated that enough energy has been provided to the grid, the PED 110 can command the power device 120 to stop injecting current into the system.

**The** detection of a fault can be implemented by introducing a predefined threshold value on the magnitude of the current or on the rate of change of the current. When an instantaneous or average current level is detected that exceeds this threshold, either by the detection module 111 or by other devices that communicate with the detection module 111, the control module can be activated. This threshold may be preferably higher than a nominal current value at the location of detection in the system, but lower than a protection response configuration setting of the protection devices. Example protection response configuration settings are 3 or 5 times the nominal current level. The threshold value for the detection module 111 can be lower, for example 1.5 times the nominal current level.

**The** power device 120 is preferably implemented as a static device, which is 'static' for example in that it is not a rotating device. Examples of such a static device are PE converters. Conventional grid-connected PE converters (e.g., those tying renewable sources into the grid) typically have a current rating that is not substantially higher than the nominal current of the power grid. However, the power device 120 is preferably rated to provide enough additional fault current to induce a protection response, which may be substantially higher than the nominal grid current.

The power device 120 may, in an example, be integrated into a PE converter on the grid, for example. To do this in an existing PE converter, one semiconductor cell of the converter can be oversized and connected to a dedicated energy source, for example.

Generally, the PED 110 and/or power device 120 can be stand-alone devices, or added as part of a converter station, e.g., in combination with passive components and/or a mechanical switch. Communication between the detection module 111 and the control module 112, and/or between the PED 110 and the power device 120, can be wired or wireless, preferably wired, for lower latency.

**As** discussed above, once the fault current is added to the grid, the current may surpass the threshold value of the already existing protection devices, which might then execute measures to prevent the current form flowing in the grid. An example of such measures is to open a circuit breaker 210b to stop the current from flowing. It is appreciated that other safety measures might be in place depending on the structure of the grid and the anticipated fault. However, the additional fault current from the power device 120 alone may not trigger the protection device 210b. Additional power devices may be controlled (e.g., by the same PED 110 or by others provided with an indication of the fault) to provide further additional fault currents. Hence, further PEDs 110 may be introduced onto a power network to provide support for more inverter-based resources (IBRs) to be added to the power network.

The current/energy injected into the grid 200 from the power device 120 may be provided by an energy storage (not shown in detail). Such an energy storage preferably provides substantially instant energy to the grid upon an instruction from the control module 112. The additional fault current from input energy can be predetermined, for example a calculated pulse, which may be pre-calculated or calculated substantially in real-time depending on the nature of the fault or the like. The additional fault current may, for example, correspond to a total discharge of the energy storage, and hence the energy storage may be sized accordingly.

The protection system 100, preferably further comprises an energy storage monitoring module configured to maintain the energy storage at a threshold or minimum energy level. Recharging/replenishing of the energy storage before and/or after a fault event can be carried out by the energy storage monitoring module, which may be part of or associated with the control module 112.

Possible energy sources include electrical energy from the grid through capacitors, inductors or combinations of these; chemical energy such as electrochemical batteries, hydrogen fuel-cells or flow-batteries or a fuel motor and generator; thermal energy such as a heat storage element coupled to a turbine and an electrical generator; gravitational potential such as a lifted mass that is released when energy is desired, coupled to an electrical generator; elastic potential such as a spring connected to a linear generator or to an oscillating machine with an internal generator; kinetic energy such as a rotating mass connected to a generator; or some combination thereof and/or some other form of energy storage.

**As** an example alternative or additional control, the protection enhancement device 110 (e.g., the control module 112 therein) may be further configured to control the protection device 210a to open the switch on the other branch 200a of the power network 200. The PED 110 may therefore be in communication, directly or indirectly, with the protection device(s) 210a and/or 210b so that they can be directly controlled to open. In some examples, this control may be a redundant operation as well as the fault current injection. In other examples, this control may be an alternative operation, e.g., for branches or locations in the power network where an additional fault current is not, or cannot, be injected, but a protection response is nonetheless desired.

In further examples, the detection module 111 can receive a command from other, additional (detection) devices, that a fault is present on the grid, upon which it indicates the fault to the control module 112. That is, the detection module 111 may not directly detect the fault 220 but may instead be informed from other devices (including, for example, a central grid controller) that the fault 220 has been detected. Hence, as an alternative or addition to causing the power device 120 to inject the additional fault current, the control module 112 may communicate/transmit (e.g., directly or as a broadcast) an indication that a fault has been detected.

Hence, a protection network may be formed on the grid 200 that includes communication and co-ordination between PEDs, power devices, detection means, and/or protection devices, to thereby enact fast-responding appropriate protection responses, or even pro-active protective measures, on the grid 200.

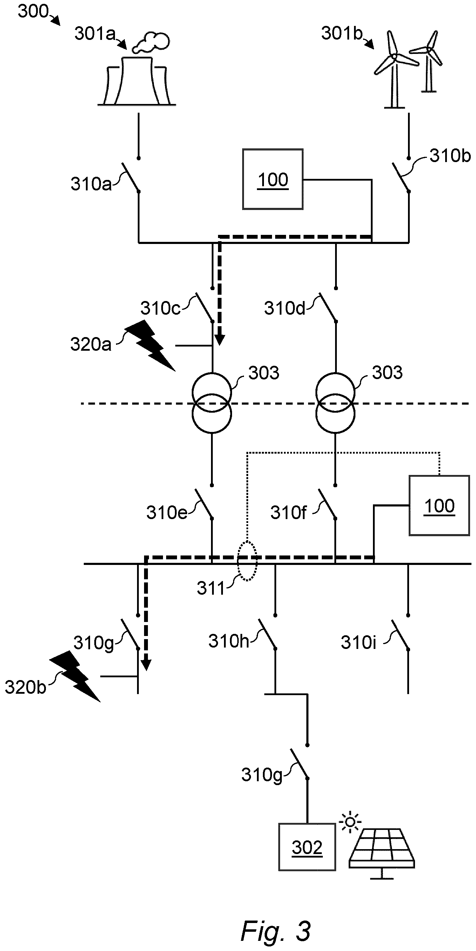

**An** example power network 300 is shown in figure 3, having multiple protection systems 100 arranged thereon. One or both of the protection systems 100 may correspond substantially to the protection system 100 described in connection with figure 1. Alternatively, one or both of the protection systems 100 may have more or fewer functionalities than said protection system 100.

**The** illustrated network 300 comprises a substation that is transforming high voltage (HV) or medium voltage (MV) to MV or low voltage (LV) respectively - from the upper bus to the lower bus as illustrated - using two transformers 303. It is seen that the HV/MV upper bus is supplied by renewable generation sources 301a and 301b (including a converter) and has limited fault current.

Two example scenarios are considered in the context of the network 300 illustrated in figure 3. In one scenario, a protection system 100 is placed on the HV/MV bus and is able to detect a fault 320a on the HV/MV side of the substation. An additional fault current is provided in response, as shown as a dashed arrow, ensuring that the circuit breaker 310c is able to open and clear the fault 320a.

In another scenario, a protection system 100 is on the MV/LV side of the substation and has a detection location 311 in between the two transformers 303. A fault 320b occurs on a branch with a protection device 310g. The available fault current is limited in this scenario by the renewable generation 301a and 301b on the HV/MV side and the impedance of the transformer 303. Also, there is not enough fault current capacity from the solar (PV) converter 302 on the MV/LV side. When the protection system 100 receives an indication of the fault 320b, as shown as a dashed arrow, it provides enough current to open the circuit breaker 310g and to clear the fault.

While the present disclosure is susceptible to various modifications and alternative forms, specific embodiments are shown and described above by way of example in relation to the drawings, with a view to clearly explaining the various advantageous aspects of the present disclosure. It should be understood, however, that the detailed description herein and the drawings attached hereto are not intended to limit the disclosure to the particular form disclosed. Rather, the intention is to cover all modifications, equivalents, and alternatives falling within the scope of the following claims.

## Claims

1. A protection enhancement device for a power network, comprising:
a control module configured to, in response to a detection of a fault current at a detection location in the power grid, control a power device to inject an additional current to supplement the fault current in the power network to thereby cause a protection response on the power network.

2. The device according to claim 1, wherein the control module is configured to control the injection of the additional fault current to increase the total current on the power network to above a protection response configuration setting where a protection response is caused on the power network.

3. The device according to claim 1 or claim 2, wherein the control module is configured to stop injecting the additional fault current into the power network in response to a determination that the protection response has been caused and/or a determination that a predetermined amount of energy has been injected into the power network.

4. A protection enhancement device for a power network, comprising:
a control module configured to, in response to a detection of a fault current at a detection location in the power grid, control a protection device to initiate a protection response on the power network,
wherein the detected fault current has a different value to a protection response configuration setting for the protection device at which a protection response of the protection device is caused.

5. The device according to any preceding claim, further comprising a detection module configured to detect the fault current.

6. The device according to claim 5, wherein detecting a fault current comprises determining that a current value at the detection location exceeds a threshold current value.

7. The device according to claim 6, wherein the threshold current value is substantially higher than a nominal current value at the detection location, and lower than the protection response configuration setting.

8. The device according to any preceding claim, wherein the detection of a fault current comprises receiving an indication that a fault current has been detected on the power network.

9. The device according to any preceding claim, wherein the control module is further configured to, in response to the detection of a fault current at a detection location in the power network, transmit an indication that a fault current has been detected on the power network.

10. A protection system comprising the protection enhancement device according to any preceding claim, and further comprising a power device configured to provide the additional fault current from an energy storage into the power network in response to a control from the control module.

11. The protection system according to claim 10, wherein the power device is a power electronic converter.

12. The protection system according to claim 10 or claim 11, further comprising the energy storage.

13. The protection system according to claim 12, wherein the energy storage comprises one or more of:
electrical energy storage,
chemical energy storage,
thermal energy storage,
gravitational potential energy storage, and
elastic potential energy storage.

14. The protection system according to 10 to 13, further comprising an energy storage monitoring module configured to maintain the energy storage at a threshold energy level.

15. The protection system according to any of claims 12 to 14, wherein the energy storage is configured to be replenished from the power network.

16. A power network comprising at least one power enhancement device according to any of claims 1 to 9 or a protection system according to any of claims 10 to 15.

17. A protection method for a power network comprising:
in response to an indication of a fault current at a location on the power network, controlling a power device to provide an additional fault current to the power grid to thereby cause a protection response on the power network.

18. A protection method for a power network comprising:
in response to an indication of a fault current at a location on the power network, controlling a protection device to initiate a protection response on the power network,
wherein the detected fault current has a different value to a protection response configuration setting for the protection device at which a protection response of the protection device is caused.
